# EUROPEAN PATENT APPLICATION

(11) **EP 4 723 558 A1**
(43) Date of publication of application: **08.04.2026**
(21) Application number: 24830557.5
(22) Date of filing: 18.06.2024
(51) Int. Cl.: H04L 12/10

(54) **VOLTAGE REGULATION APPARATUS, RADIO FREQUENCY AMPLIFICATION APPARATUS AND VOLTAGE SELECTION METHOD**

(30) Priority: 27.06.2023 CN 202310777567
(71) Applicant: ZTE CORPORATION, Shenzhen, Guangdong 518057 (CN)
(72) Inventor: WANG, Hao, Shenzhen, Guangdong 518057 (CN); WANG, Linguo, Shenzhen, Guangdong 518057 (CN); ZHANG, Bin, Shenzhen, Guangdong 518057 (CN); LI, Tao, Shenzhen, Guangdong 518057 (CN); DU, Yonghong, Shenzhen, Guangdong 518057 (CN); GAO, Xiaoguang, Shenzhen, Guangdong 518057 (CN)
(74) Representative: Ziebig Hengelhaupt Intellectual Property Attorneys Patentanwaltskanzlei PartGmbB
(86) International application number: PCT/CN2024/099740
(87) International publication number: WO 2025/001911

(57) **Abstract**

A voltage regulation apparatus, a radio frequency amplification apparatus and a voltage selection method. The voltage regulation apparatus (100, 610) comprises: a voltage controller (101, 611) and a multi-level power supply modulator (102, 612). The multi-level power supply modulator (102, 612) comprises a plurality of branches; an input voltage (V1, V2, V3, V4, ...., Vn) is input into an input end of any branch, and the other end thereof is connected to a voltage output end of the multi-level power supply modulator (102, 612), each branch being provided with one or two switching transistors. The controller (101, 611) is used for generating a voltage selection signal (DRV1, DRV2, DRV3, DRV4, DRV5) according to a received voltage regulation command, and sending the voltage selection signal (DRV1, DRV2, DRV3, DRV4, DRV5) to the multi-level power supply modulator (102, 612). The multi-level power supply modulator (102, 612) is used for controlling, according to the voltage selection signal (DRV1, DRV2, DRV3, DRV4, DRV5), the completion of a circuit from the input end of one target branch among the plurality of branches to a voltage output port.

## Description

### CROSS-REFERENCE TO RELATED APPLICATIONS

The present application claims priority to Chinese Application No. 202310777567.9, filed with the Chinese Patent Office on June 27, 2023, with the title "VOLTAGE REGULATION APPARATUS, RADIO FREQUENCY AMPLIFICATION APPARATUS AND VOLTAGE SELECTION METHOD", the disclosure of which is hereby incorporated by reference in its entirety.

### TECHNICAL FIELD

The present application belongs to the field of wireless communication, specifically relating to a voltage regulation apparatus, a radio frequency amplification apparatus, and a voltage selection method.

### BACKGROUND

With the continuous development of communication technology, wireless communication devices utilize technologies such as 3G, 4G or 5G. The modulation methods of communication systems are becoming increasingly complex, resulting in high peak-to-average power ratio (PAPR) and high bandwidth in transmitted and received signals. In 5G communication systems, the traditional method of supplying power to the radio frequency power amplifier with a constant voltage significantly reduces the amplifier's efficiency.

Currently, the communication industry faces requirements for energy conservation and consumption reduction, and there is no room for significant improvement in the efficiency of the power supply section in traditional fixed-voltage power supply methods. Therefore, how to achieve dynamic adjustment of the supply voltage is a technical problem that needs to be solved in related technologies.

### SUMMARY

The purpose of the embodiments of the present application is to provide a voltage regulation apparatus, a radio frequency amplification apparatus, and a voltage selection method.

In a first aspect, an embodiment of the present application provides a voltage regulation apparatus, comprising: a voltage controller and a multi-level power supply modulator, wherein the multi-level power supply modulator comprises multiple branches, an input voltage is input into an input terminal of any branch, and the other terminal thereof is connected to a voltage output terminal of the multi-level power supply modulator, each branch is provided with one or two switching transistors; wherein, the voltage controller is used for generating a voltage selection signal according to a received voltage regulation command, and sending the voltage selection signal to the multi-level power supply modulator; the multi-level power supply modulator is used for controlling, according to the voltage selection signal, the conduction (also known as closure) of a circuit from the input terminal of a target branch among the multiple branches to the voltage output terminal.

In a second aspect, an embodiment of the present application provides a radio frequency amplification apparatus, comprising a radio frequency power amplifier and a voltage regulation apparatus according to the first aspect, wherein the power input terminal of the radio frequency power amplifier is connected to the voltage output terminal of the voltage regulation apparatus, and the Radio frequency power amplifier is used to amplify and output the input RF signal under the action of the output voltage of the voltage regulation apparatus.

In a third aspect, an embodiment of the present application provides a voltage selection method, applied to a voltage regulation apparatus, the method comprising: generating, by a voltage controller of the voltage regulation apparatus, a voltage selection signal according to a received voltage regulation command, and sending the voltage selection signal to a multi-level power supply modulator of the voltage regulation apparatus; controlling, by the multi-level power supply modulator and according to the voltage selection signal, all switching transistors on a target branch to be turned on, controlling a second type of switching transistor on a third branch to be turned on, and controlling a second type of switching transistor on a fourth branch to be turned off, wherein the input voltage of the target branch matches the target voltage selected by the voltage selection signal, the third branch is a branch among multiple branches with an input voltage at an input terminal lower than an input voltage of the target branch, and the fourth branch is a branch among the multiple branches with an input voltage at an input terminal higher than the input voltage of the target branch.

### BRIEF DESCRIPTION OF DRAWINGS

Fig. 1 shows a structure schematic diagram of a voltage regulation apparatus provided in an embodiment of the present application;
Fig. 2 shows a circuit diagram of a multi-level power supply modulator provided in an embodiment of the present application;
Fig. 3 shows a circuit diagram of a voltage controller provided in an embodiment of the present application;
Fig. 4a shows a schematic diagram of a continuously switching signal provided in an embodiment of the present application;
Fig. 4b shows a schematic diagram of a discontinuously switching signal provided in an embodiment of the present application;
Fig. 5a shows a circuit diagram of another multi-level power supply modulator provided in an embodiment of the present application;
Fig. 5b shows a circuit diagram of yet another multi-level power supply modulator provided in an embodiment of the present application;
Fig. 6a shows a structure schematic diagram of a radio frequency amplification apparatus provided in an embodiment of the present application;
Fig. 6b shows a structure schematic diagram of another radio frequency amplification apparatus provided in an embodiment of the present application;
Fig. 7 shows a flowchart of a signal selection method provided in an embodiment of the present application.

### DETAILED DESCRIPTION

The following will clearly and completely describe the technical solutions in the embodiments of the present application in conjunction with the accompanying drawings in the embodiments of the present application. Obviously, the described embodiments are part of the embodiments of the present application, not all of them. Based on the embodiments in the present application, all other embodiments obtained by those skilled in the art without making creative efforts shall fall within the protection scope of the present application.

In the specification and claims of the present application, terms such as "first" and "second" are used to distinguish similar objects, rather than to describe a specific order or sequence. It should be understood that data used in this way can be interchanged under appropriate circumstances, so that the embodiments of the present application can be implemented in an order other than those illustrated or described herein. Moreover, the objects distinguished by "first", "second", etc., are generally of a certain type, and the number of objects is not limited. For example, the first object can be one or multiple. In addition, "and/or" in the specification and claims indicates at least one of the connected objects, and the character "/" generally indicates that the associated objects before and after are in an "or" relationship.

In 5G communication, fast voltage regulation technology usually refers to adjusting the supply voltage of the radio frequency power amplifier according to changes in the output power of the radio frequency power amplifier. The time required to achieve the adjustment of the supply voltage is an extremely short time interval, which is at the nanosecond level.

Traditional radio frequency power amplifier power supplies usually adopt switching power supply schemes, which have a slow voltage regulation speed and cannot meet the requirement of rapid voltage regulation for power supply voltage under 5G communication technology. To achieve the requirement of rapid voltage regulation, it is necessary to increase the switching frequency of the switching transistor. However, under ultra-high switching frequencies, the switching loss is large, resulting in low efficiency of the switching power supply. To address this problem, the embodiment of the present application provides a voltage regulation apparatus, a radio frequency amplification apparatus, and a voltage selection method to achieve rapid voltage regulation.

The following describes in detail the voltage regulation apparatus, radio frequency amplification apparatus, and voltage selection method provided in the embodiment of the present application through specific embodiments and their application scenarios with reference to the accompanying drawings.

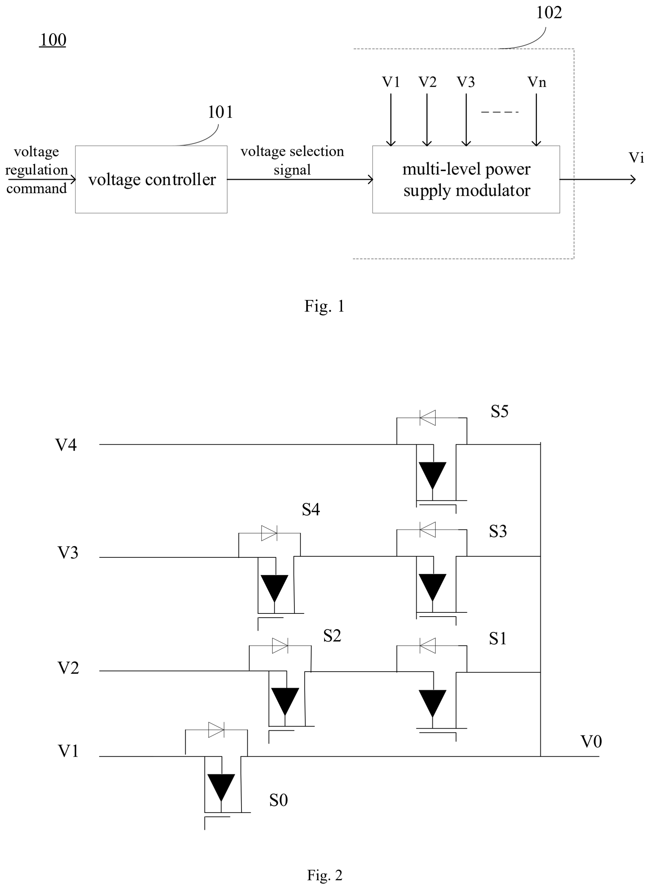

Fig. 1 is a structure schematic diagram of the voltage regulation apparatus provided in an embodiment of the present application. As shown in Fig. 1, the voltage regulation apparatus 100 provided in the embodiment of the present application comprises: a voltage controller 101 and a multi-level power supply modulator 102.

Wherein the multi-level power supply modulator 102 comprises multiple branches, an input voltage is input into an input terminal of any branch, and the other terminal thereof is connected to a voltage output terminal of the multi-level power supply modulator 102, each branch is provided with one or two switching transistors; the voltage controller 101 is used for generating a voltage selection signal according to a received voltage regulation command, and sending the voltage selection signal to the multi-level power supply modulator 102; the multi-level power supply modulator 102 is used for controlling, according to the voltage selection signal, the conduction of a circuit from the input terminal of a target branch among the plurality of branches to the voltage output terminal.

In an embodiment of the present application, in order to save costs, the input voltages at the input terminals of each branch can be completely different. It can also be said that the input voltage is input to the input terminal of any branch, and any two of the input voltages V1, V2, V3, ..., Vn are different.

For example, suppose there are 4 branches, and the input voltages of each branch can be 5V, 10V, 15V, and 20V respectively, so that an output voltage of one of 5V, 10V, 15V, and 20V can be provided.

In an embodiment of the present application, the voltage regulation apparatus 100 comprises the voltage controller 101 and multi-level power supply modulator 102. The voltage controller 101 is used to generate a voltage selection signal according to the received voltage regulation command. It should be noted that the voltage controller 101 can be a digital controller or an analog controller. As shown in Fig. 1, after the voltage controller 101 generates a voltage selection signal, it sends the voltage selection signal to the multi-level power supply modulator 102, and the multi-level power supply modulator 102 performs voltage selection and output according to the voltage selection signal. The multi-level power supply modulator 102 comprises multiple branches, and an input voltage is input to the input terminal of any branch. One voltage Vi is selected from the input voltages V1, V2, V3, ..., Vn as the output voltage according to the voltage selection signal.

It should be noted that the voltage regulation apparatus 100 is not limited to use in wireless communication base stations, other wireless communication devices are also within the scope of description of the embodiments of the present application. For example, mobile phones, Internet of Things devices, etc.

An embodiment of the present application provides a voltage regulation apparatus 100, which comprises a voltage controller 101 and a multi-level power supply modulator 102, wherein the multi-level power supply modulator 102 comprises multiple branches, an input voltage is input into an input terminal of any branch, and the other terminal thereof is connected to a voltage output terminal of the multi-level power supply modulator, each branch is provided with one or two switching transistors; wherein the voltage controller 101 is used for generating a voltage selection signal according to a received voltage regulation command, and sending the voltage selection signal to the multi-level power supply modulator102; the multi-level power supply modulator 102 is used for controlling, according to the voltage selection signal, the conduction of a circuit from the input terminal of a target branch among the plurality of branches to the voltage output terminal, so that the apparatus 100 can quickly select one voltage from multiple input voltages as the output, realize rapid switching of voltage output, reduce the power consumption of the powered apparatus, and achieve energy conservation.

In an embodiment of the present application, the switching transistors on multiple branches may include the following two types of switching transistors.
(1) A first type of switching transistor. A first terminal of the first type of switching transistor is connected to the input terminal, and a second terminal thereof is connected to either the voltage output terminal or a second terminal of a second type of switching transistor, when the first type of switching transistor is turned off (also known as disconnected), the circuit in a first direction is conductive, and the circuit in a second direction is off, and when the first type of switching transistor is turned on, both the circuit in the first direction and the circuit in the second direction are conductive; wherein the first direction is the direction from the first terminal of the first type of switching transistor to the second terminal of the first type of switching transistor, and the second direction is the direction from the second terminal of the first type of switching transistor to the first terminal of the first type of switching transistor. The first type of switching transistor, when in the off state, has characteristics similar to a diode. It turns on under forward voltage and turns off under reverse voltage, thereby functioning to prevent high-voltage backflow. Therefore, it can also be called an anti-reverse switching transistor.
(2) A second type of switching transistor. A first terminal of the second type of switching transistor is connected to the voltage output terminal, and a second terminal of the second type of switching transistor is connected to either the input terminal or the second terminal of the first type of switching transistor, when the second type of switching transistor is turned off, the circuit in a third direction is conductive, and the circuit in a fourth direction is off, and when the second type of switching transistor is turned on, both the circuit in the third direction and the circuit in the fourth direction are conductive; wherein the third direction is the direction from the first terminal of the second type of switching transistor to the second terminal of the second type of switching transistor, and the fourth direction is the direction from the second terminal of the second type of switching transistor to the first terminal of the second type of switching transistor. The second type of switching transistor, when in the off state, the voltage of the branch where the second type of switching transistor is located will not be gated; when in the on state, the voltage of the branch is selected as the output voltage. Therefore, the second type of switching transistor can also be called a gating switching transistor.

In an embodiment of the present application, among the above-mentioned multiple branches, the branch with the lowest input voltage at the input terminal is provided with a first switching transistor, and the first switching transistor is the first type of switching transistor; the branch with the highest input voltage at the input terminal is provided with a second switching transistor, and the second switching transistor is the second type of switching transistor. With this implementation method, the number of switching transistors in the voltage regulation apparatus can be reduced, thereby saving costs.

In an embodiment of the present application, among the above-mentioned multiple branches, each branch with the input voltage between the lowest input voltage and the highest input voltage at the input terminal is provided with two switching transistors, one of which is the first type of switching transistor and the other is the second type of switching transistor. However, in practical applications, the branches with the input voltage between the lowest input voltage and the highest input voltage at the input terminal is not limited to having only one pair of first type switching transistor and second type switching transistor, for example, two pairs of first type switching transistor and second type switching transistor can also be provided. With this implementation method, the voltage regulation apparatus has fewer switching transistors, a simple structure, and higher efficiency in dynamically adjusting the supply voltage.

In an embodiment of the present application, the switching transistors of the voltage regulation apparatus may comprise: one or more semiconductors with switching characteristics, for example, the switching transistor may comprise one or more metal-oxide-semiconductor field-effect transistors (MOS). The source of the first type of switching transistor is connected to the input voltage, and its drain is connected to the output terminal or the drain of the second type of switching transistor, while the source of the second type of switching transistor is connected to the output terminal, and its drain is connected to the input terminal or the drain of the first type of switching transistor.

Taking the switching transistor as a MOS transistor, and the voltage regulation apparatus comprising 4 branches as an example, Fig. 2 shows a circuit diagram of the multi-level power supply modulator provided by the embodiment of the present application.

As shown in Fig. 2, the input voltages of the 4 branches, namely V1, V2, V3 and V4, are the input voltages of the four branches: the first voltage, the second voltage, the third voltage, and the fourth voltage respectively, V0 is the output voltage of the multi-level power supply modulator with 4 input voltages, where V0 can be any one of V1, V2, V3 and V4. Wherein the magnitude relationship of the input voltages can satisfy V4 > V3 > V2 > V1, and the voltage value of each input voltage can be determined after mutual matching according to the load power.

As shown in Fig. 2, the voltage regulation apparatus comprises 6 switching transistors (S0-S5), the switching transistors S0, S2 and S4 are the first type of switching transistor used to prevent voltage backflow, the first terminal of the first type of switching transistor is connected to the input terminal, and the second terminal is connected to the voltage output terminal or the second terminal of the second type of switching transistor. Since the first type of switching transistors S0, S2 and S4, when turned off (also known as disconnected), exhibit the characteristics similar to a diode, turning on under forward voltage and turning off under reverse voltage, thereby functioning to prevent high-voltage backflow; the first type of switching transistors S0, S2 and S4, when turned on, no longer provide reverse protection. In other words, when the first type of switching transistor is turned off, the circuit in the first direction is conductive, and the circuit in the second direction is off, and when the first type of switching transistor is turned on, both the circuit in the first direction and the circuit in the second direction are conductive.

The switching transistors S1, S3 and S5 are the second type of switching transistor that are gated by the control voltage, the first terminal of the second type of switching transistor is connected to the voltage output terminal, and the second terminal of the second type of switching transistor is connected to either the input terminal or the second terminal of the first type of switching transistor. When the second type of switching transistor is turned off, the voltage on the branch where the second type of switching transistor is located will not be gated; when the second type of switching transistor is turned on, the voltage on its branch is selected as the output voltage; therefore when the second type of switching transistor is turned off, the circuit in the third direction is conductive, and the circuit in the fourth direction is off, and when the second type of switching transistor is turned on, both the circuit in the third direction and the circuit in the fourth direction are conductive.

In Fig. 2, in the multi-level power supply modulator with 4 input voltages, the branch with the lowest input voltage V1 at the input terminal is provided with a first switching transistor S0, and the first switching transistor S0 is the first type of switching transistor; the branch with the highest input voltage V4 at the input terminal is provided with a second switching transistor S5, and the second switching transistor S5 is the second type of switching transistor; the branch with the input voltages V2 and V3 between the lowest input voltage V1 and the highest input voltage V4 at the input terminal is provided with two switching transistors, one of which is the first type of switching transistor and the other is the second type of switching transistor; wherein the two switching transistors provided on the branch where V2 is located are the first type of switching transistor S2 and the second type of switching transistor S1; the two switching transistors provided on the branch where V3 is located are the first type of switching transistor S4 and the second type of switching transistor S3.

In an embodiment of the present application, the first type of switching transistor on the first branch and the second type of switching transistor on the second branch are complementary logic, wherein the first branch is any branch among the plurality of branches except the branch with the highest input voltage at the input terminal, and the second branch is the branch among the plurality of branches with the smallest difference between the input voltage thereof and the input voltage of the first branch, and the input voltage of the second branch is higher than the input voltage of the first branch. That is to say, the anti-reverse switching transistor of any input voltage and the gating switching transistor on the branch where an input voltage is higher than this input voltage and has the smallest voltage difference are complementary logic.

For example, in Fig. 2, S0 and S1 are complementary logic, S2 and S3 are complementary logic, and S4 and S5 are complementary logic. In the embodiment of the present application, the complementary logic between the first type of switching transistor on the first branch and the second type of switching transistor on the second branch means that the conduction states of the first type of switching transistor on the first branch and the second type of switching transistor on the second branch are complementary. For example, if the first type of switching transistor on the first branch is turned on, then the second type of switching transistor on the second branch is turned off, or if the first type of switching transistor on the first branch is turned off, then the second type of switching transistor on the second branch is turned on.

In an embodiment of the present application, within the dead zone between the first type of switching transistor on the first branch and the second type of switching transistor on the second branch, the first type of switching transistor on the first branch is turned off before the second type of switching transistor on the second branch is turned on, or the first type of switching transistor on the first branch is turned on after the second type of switching transistor on the second branch is turned off.

For example, in Fig. 2, the first type of switching transistor S0 on the first voltage branch and the second type of switching transistor S1 on the second voltage branch are complementary logic. Since switching transistors require a certain amount of time to switch, it is necessary to leave a certain dead zone when controlling the switching transistors to prevent both switching transistors S0 and S1 from being turned on simultaneously, which would cause the second voltage to be directly reverse-injected into the first voltage. Therefore, the first type of switching transistor on the first branch is turned off before the second type of switching transistor on the second branch is turned on, or the first type of switching transistor on the first branch is turned on after the second type of switching transistor on the second branch is turned off. For example, when the voltage switches from the first voltage to the second voltage, the anti-reverse switching transistor S0 changes from turned on to turned off, and after a dead zone, the gating switching transistor S1 changes from turned off to turned on. When the voltage switches from the second voltage to the first voltage, the gating switching transistor S1 changes from turned on to turned off, and after a dead zone, the anti-reverse switching transistor S0 changes from turned off to turned on.

Through the above embodiments, the multi-level power supply modulator can maintain a continuous output current during voltage switching, thereby preventing sudden changes in the output voltage of the multi-level power supply modulator.

In an embodiment of the present application, all the switching transistors on the target branch are turned on, the second type of switching transistor on the third branch is turned on, and the second type of switching transistor on the fourth branch is turned off, wherein the third branch is the branch among the multiple branches with the input voltage at the input terminal lower than the input voltage of the target branch, and the fourth branch is the branch among the multiple branches with the input voltage at the input terminal higher than the input voltage of the target branch. In the embodiment of the present application, the input voltage of the target branch is the output voltage selected by the multi-level power supply modulator. That is to say, when the target voltage is gated, all the switching transistors on the branch where the target voltage is located are turned on, and the gating switching transistors on the branches of the input voltages lower than the target voltage (if present) are turned on, while the gating switching transistors on the branches of the input voltages higher than the target voltage (if present) are turned off.

In an embodiment of the present application, the voltage controller 101 can be specifically used for sending the first voltage selection signal to the control terminal of the second type of switching transistor on the second branch and the second voltage selection signal to the control terminal of the first type of switching transistor on the first branch when the target voltage signal is equal to the input voltage of the first branch, and sending the second voltage selection signal to the control terminal of the second type of switching transistor on the second branch and the first voltage selection signal to the control terminal of the first type of switching transistor on the first branch when the target voltage signal is not equal to the input voltage of the first branch, wherein the first voltage selection signal is the signal that controls the first type of switching transistor or the second type of switching transistor to turn off, and the second voltage selection signal is the signal that controls the first type of switching transistor or the second type of switching transistor to turn on.

That is to say, the voltage controller 101 can input corresponding voltage selection signals to the control terminal of the first type of switching transistor on the first branch and the control terminal of the second type of switching transistor on the second branch respectively according to the magnitude relationship between the voltage value of the target voltage signal and the voltage value of the input voltage of the first branch, so as to realize the complementary logic between the first type of switching transistor on the first branch and the second type of switching transistor on the second branch.

Optionally, the first voltage selection signal is a level signal with the voltage value less than or equal to the threshold, which can also be referred to as a low level signal; the second voltage selection signal is a level signal with the voltage value higher than the threshold, which can also be referred to as a high level signal. Wherein the specific value of the threshold can be determined according to the conduction conditions of the switching transistor actually used, and is not limited in the embodiments of the present application. For example, for a MOS transistor, the threshold can be the turn-on voltage of the MOS transistor (which can also be called the threshold voltage).

In an embodiment of the present application, the voltage controller can be composed of analog signals and analog devices, or it can be composed of digital signals and digital chips. For example, the voltage controller may comprise n pairs of comparators and NOT gates, each pair of the comparator and NOT gates correspond to one first branch (that is, any branch in the multi-level power supply modulator except the branch with the highest input voltage), n is the number of branches in the multi-level power supply modulator excluding the branch with the highest input voltage among the multiple branches. Wherein in any pair of the comparator and NOT gate, the output terminal of the comparator is connected to the control terminal of the second type of switching transistor on the second branch, and the output terminal of the comparator is connected to the control terminal of the first type of switching transistor on the first branch through the NOT gate; the target voltage signal and the input voltage of the first branch are input to the input terminal of the comparator, when the target voltage signal is equal to the input voltage of the first branch, the comparator outputs the first voltage selection signal, and when the target voltage signal is not equal to the input voltage of the first branch, the comparator outputs the second voltage selection signal.

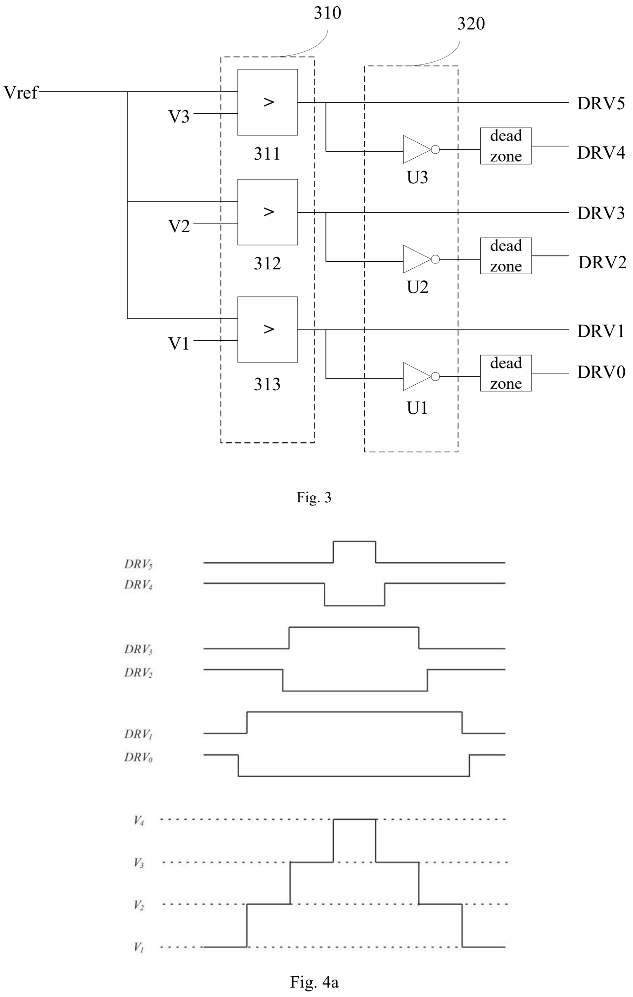

Taking the 4 branches included in the multi-level power supply modulator as an example, as shown in Fig. 3, the voltage controller comprises: 3 pairs of comparators and NOT gates: comparator 311 and NOT gate U3, comparator 312 and NOT gate U2, comparator 313 and NOT gate U1. Wherein the output terminal of the comparator 311 is connected to the control terminal of the second type of switching transistor on the branch with the input voltage of V4, and the output terminal of the comparator 311 is connected to the control terminal of the first type of switching transistor on the branch with the input voltage of V3 through the NOT gate U3, the output terminal of the comparator 312 is connected to the control terminal of the second type of switching transistor on the branch with the input voltage of V3, and the output terminal of the comparator 312 is connected to the control terminal of the first type of switching transistor on the branch with the input voltage of V2 through the NOT gate U2, the output terminal of the comparator 313 is connected to the control terminal of the second type of switching transistor on the branch with the input voltage of V2, and the output terminal of the comparator 313 is connected to the control terminal of the first type of switching transistor on the branch with the input voltage of V1 through the NOT gate U1; the input terminal of comparator 311 is input with the target voltage signal (Vref) and V3, the input terminal of comparator 312 is input with the target voltage signal (Vref) and V2, and the input terminal of comparator 313 is input with the target voltage signal (Vref) and V1.

Since switching transistors require a certain amount of time to switch, it is necessary to leave a certain dead zone when controlling the switching transistors to prevent the two complementary switching transistors from being turned on or turned off simultaneously, which would cause voltage backflow or discontinuous output current during switching, leading to sudden voltage changes. Therefore, in the embodiment of the present application, a dead zone can be added after the NOT gate.

Taking the control of a 4-input multi-level power supply modulator as shown in Fig. 2 by the voltage controller as shown in Fig. 3 as an example, the four input voltages satisfy V4 > V3 > V2 > V1. Vref is a reference voltage signal (i.e., the target voltage signal). Vref is compared with V1, V2 and V3 respectively through the comparator 310. The outputs DRV1, DRV3 and DRV5 (voltage selection signals) of the comparator 310 are the control signals for the switching transistors S1, S3, and S5 respectively; DRV0, DRV2 and DRV4 (voltage selection signals) are the control signals for S0, S2 and S4, which are obtained by inverting DRV1, DRV3 and DRV5 through the NOT gate 320 and then adding the dead zone.

When Vref = V1, i.e., V1 is the output voltage, comparator 311, comparator 312, and comparator 313 all output the first voltage selection signal, for example, DRV1, DRV3 and DRV5 are low level signals. At this time, DRV0 is obtained by inverting DRV1 through NOT gate U1 and adding the dead zone, DRV2 is obtained by inverting DRV1 through NOT gate U2 and adding the dead zone, and DRV4 is obtained by inverting DRV5 through NOT gate U3 and adding the dead zone. Therefore, at this time, the first type of switching transistor S0 on the V1 branch shown in Fig. 2 is turned on, the second type of switching transistors S1, S3 and S5 with voltages V2, V3, V4 which higher than V1 are turned off, and the first type of switching transistors S2 and S4, which are complementary to the second type of switching transistors S3 and S5, are turned on.

Optionally, when Vref = V2, comparator 311 outputs the second voltage selection signal, and comparator 312 and comparator 313 output the first voltage selection signal, for example, DRV1 is a high level signal, and the outputs DRV3 and DRV5 of the comparator 312 and comparator 313 are low level signals. The signals DRV0, DRV2 and DRV4 are obtained by inverting DRV1, DRV3 and DRV5 through NOT gate 320 and adding the dead zone, respectively. At this time, S1 and S2 on V2 branch shown in Fig. 2 are turned on, the second type of switching transistors S3 and S5 with voltages V3 and V4 higher than V2 are turned off, S0, which is complementary to S1, is turned off, and S0, which is complementary to S5, is turned on.

Optionally, when Vref = V3, comparator 311 and comparator 312 output the second voltage selection signal, and comparator 313 outputs the first voltage selection signal; for example, DRV1, DRV3 are high level signals, and DRV5 is low level signal. The signals DRV0, DRV2 and DRV4 are obtained by inverting DRV1, DRV3 and DRV5 through NOT gate 320 and adding the dead zone, respectively. At this time, S3 and S4 on V3 branch shown in Fig. 2 are turned on, the second type of switching transistor S5 with voltage V4 higher than V3 is turned off, the second type of switching transistor S1 with voltage V2 lower than V3 is turned on, S0, which is complementary to S1, is turned off.

Optionally, when Vref = V4, comparator 311, comparator 312 and comparator 313 all output the second voltage selection signals, for example, DRV1, DRV3 and DRV5 are high level signals. The signals DRV0, DRV2 and DRV4 are obtained by inverting DRV1, DRV3 and DRV5 through NOT gate 320 and adding the dead zone, respectively. At this time, S5 on V4 branch shown in Fig. 2 is turned on, the second type of switching transistors S3 and S5 with voltages V3 and V2 lower than V4 are turned on; S2 and S0, which are complementary to S5, S3 and S0 are turned off.

In an embodiment of the present application, the voltage can be switched continuously in the order of the first voltage, the second voltage, the third voltage and the fourth voltage, or it can be switched out of order, that is, discontinuously. For example: the voltage can be directly switched from the first voltage to the fourth voltage, or directly from the fourth voltage to the second voltage.

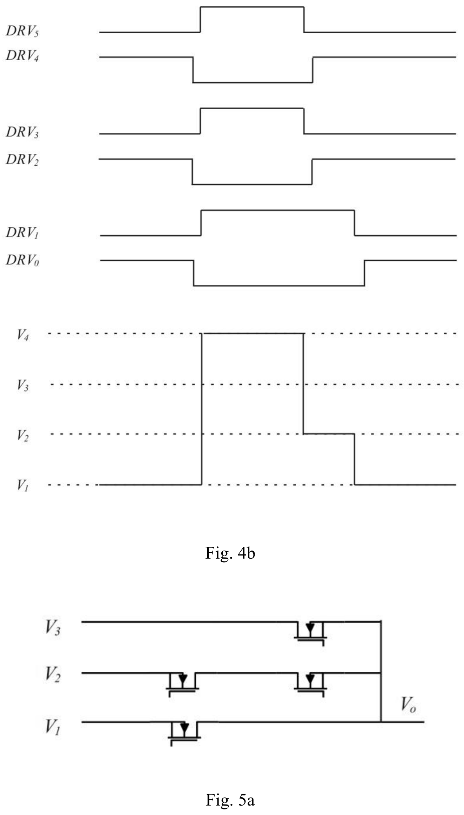

Fig. 4a shows a signal logic schematic diagram of continuous voltage switching provided in an embodiment of the present application. As shown in Fig. 4a, the first type of switching transistor S0 on the first voltage branch and the second type of switching transistor S1 on the second voltage branch are complementary logic. Since switching transistors require a certain amount of time to switch, it is necessary to leave a certain dead zone when controlling the switching transistors to prevent both switching transistors S0 and S1 from being turned on simultaneously, which would cause the second voltage to be directly reverse-injected into the first voltage. It should be noted that in Fig. 4, DRV0-DRV5 represent the control logic signals for the switching transistors S1-S5 in Fig. 2, respectively, wherein when DRV0-DRV5 are high level signals, the corresponding switching transistors are controlled to close, i.e., turned on. When DRV0-DRV5 are low level signals, the corresponding switching transistors are controlled to open, i.e., turned off.

For example, when the voltage switches from the first voltage to the second voltage, the anti-reverse switching transistor S0 changes from turned on to turned off, and after a dead zone, S1 changes from turned off to turned on. When the voltage switches from the second voltage to the first voltage, the second type of switching transistor S1 changes from turned on to turned off, and after a dead zone, the first type of switching transistor S0 changes from turned off to turned on.

When the second voltage is output, the S1 and S2 on the second voltage branch are turned on, and the S0, which is complementary to S1, is turned off. The second type of switching transistors S3 and S5 on the third and fourth voltage branches, whose voltages are higher than the second voltage, are turned off, and the S4, which is complementary to S5, is turned on.

When the third voltage is output, the S3 and S4 on the third voltage branch are turned on, and S2, which is complementary to S3, is turned off; the second type of switching transistor S5 on the fourth voltage branch, whose voltages are higher than the third voltage, is turned off, the second type of switching transistor S1 on the second voltage branch, whose voltages are lower than the third voltage, is turned on, and S0, which is complementary to S1, is turned off.

When the fourth voltage is output, the S5 on the fourth voltage branch is turned on, and S4, which is complementary to S5, is turned off; the second type of switching transistors S1 and S3 on the second and third voltage branches, whose voltages are lower than the fourth voltage, are turned on, S0, which is complementary to S1, is turned off, and S2, which is complementary to S3, is turned off.

In this embodiment, only 2 switching transistors change their states during each voltage switch, and the states of other switching transistors do not need to be changed. For example, when the output voltage switches from the first voltage to the second voltage, only switches S0 and S1 act, while other switches remain in their original states. Changes in switch states will cause switching losses. The embodiment of the present application reduces losses by reducing the number of switching operations.

Fig. 4b is a schematic diagram of discontinuous switching signals of a multi-level power supply modulator provided by the embodiment of the present application. As shown in Fig. 4b, when the output voltage switches from V1 to V4, the second type of switching transistors S1, S3 and S5 change from turned off to turned on simultaneously, the first type of switching transistors S0, S2 and S4, which are complementary to the second type of switching transistors S1, S3 and S5, change turned on to turned off after a dead zone; after the voltage switching is completed, the fourth voltage is output as the target voltage. At this time, the switching transistor S5 on the fourth voltage branch is turned on, the second type of switching transistors S1 and S3 with the third voltage and the second voltage, whose voltages are lower than the fourth voltage, are turned on, S0, S2 and S4, which are complementary to S1, S3 and S5, are turned off.

When switching the output voltage from V4 to V2, the second type of switching transistors S3 and S5 simultaneously change from turned on to turned off, after a dead time, the S2 and S4, which are complementary to S3 and S5, change from turned off to turned on; after the voltage switching is completed, the second voltage is output as the target voltage. At this time, S1 and S2 on the second branch are turned on, the second type of switching transistors S3 and S5 with the third voltage and fourth voltage (which are higher than the second voltage) are turned off, S0, which is complementary to S1, is turned off, and S4, which is complementary to S5, is turned on.

By adopting the voltage regulation apparatus provided in the embodiments of the present application, when the target voltage is gated, the gating switching transistors of all input voltages lower than the target voltage are turned on. Therefore, when the output voltage is switched, there exists a freewheeling path composed of the body diode of the anti-reverse switching transistor and the selection switching transistor, which ensures that the output current is not interrupted and maintains that the voltage does not change abruptly during this period.

For example, in the above embodiment, when the voltage is switched from the second voltage to the third voltage, there is a dead zone where both S2 and S3 are turned on. During this period, the third voltage gating switching transistor has not yet been turned on. At this time, the second voltage supplies power to the load through the body diode of the anti-reverse switching transistor S2 and the gating switching transistor S1, thereby ensuring that the output current is continuous.

In addition, the voltage regulation apparatus provided in the embodiments of the present application has fewer multi-level power supply modulator switching transistors, a simple structure, and higher voltage switching efficiency.

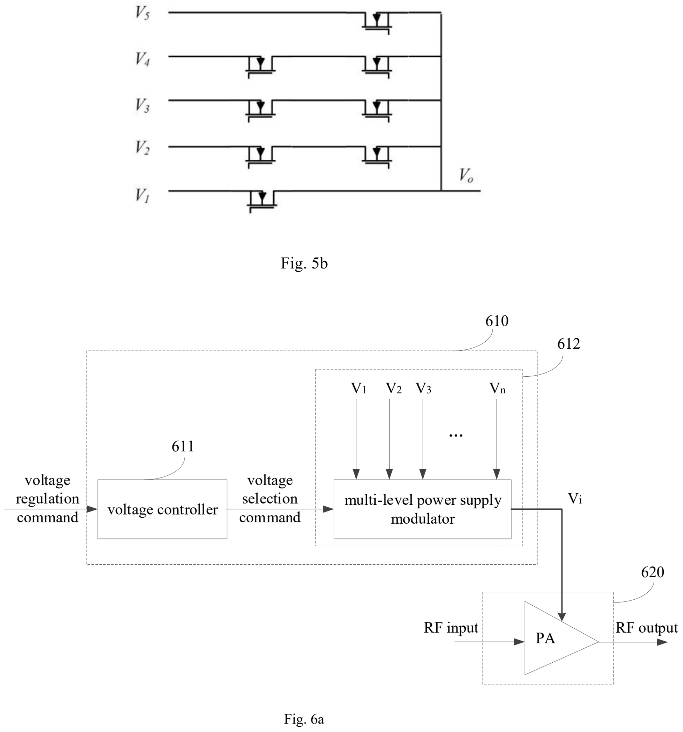

It should be noted that although the above embodiments are described by taking the multi-level power supply modulator including 4 branches as an example, it is not limited thereto. The multi-level power supply modulator provided in the embodiment of the present application may include any number of branches (which may also be referred to as voltage branches). For example, there are 3 input voltages in Fig. 5a, corresponding to 3 branches, and there are 5 input voltages in Fig. 5b, corresponding to 5 branches.

Based on the same inventive concept, the embodiments of the present application also provide a radio frequency amplification apparatus.

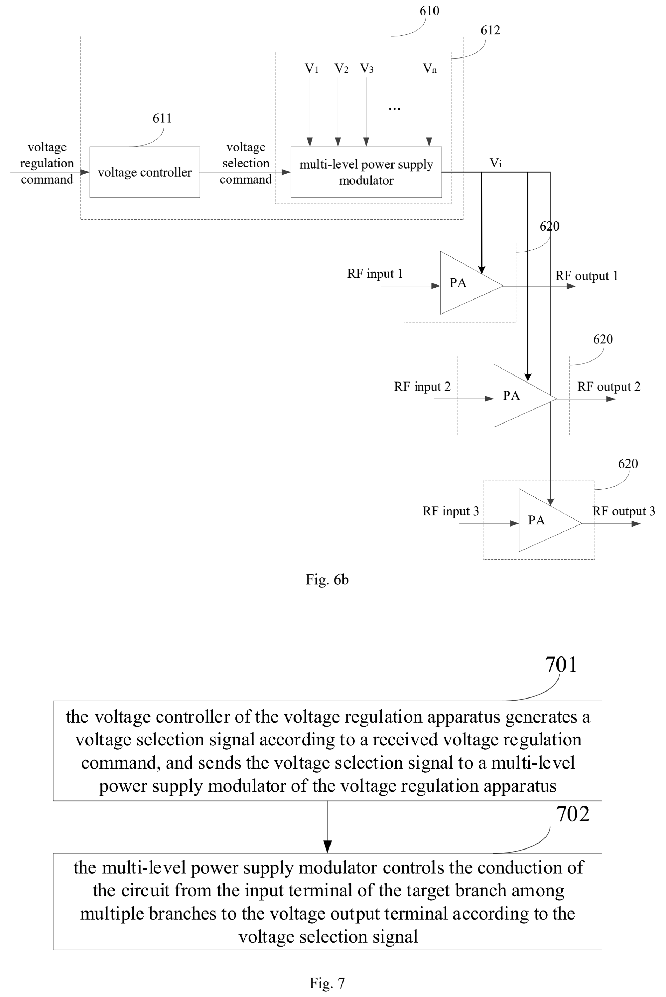

Fig. 6a is a structure schematic diagram of the radio frequency amplification apparatus provided by the embodiment of the present application. As shown in Fig. 6, it comprises a radio frequency power amplifier (PA) 620 and the voltage regulation apparatus 610 provided by any of the above embodiments. The voltage regulation apparatus 610 comprises a voltage controller 611 and a multi-level power supply modulator 612. The power input terminal of the radio frequency power amplifier 620 is connected to the voltage output terminal of the voltage regulation apparatus 610. The radio frequency power amplifier 620 is used to amplify the input radio frequency (RF) signal under the action of the output voltage of the voltage regulation apparatus 610 and then output the amplified signal.

In an embodiment of the present application, as shown in Fig. 6b, the number of radio frequency power amplifiers 602 is multiple, and the output terminal of the voltage regulation apparatus 601 is connected to the power input terminal of each of the multiple radio frequency power amplifiers 602.

In the embodiment of the present application, the radio frequency power amplifier 602 is the load of the voltage regulation apparatus 601. The output voltage Vi of the voltage regulation apparatus 601 is supplied to the drain of the radio frequency power amplifier 602, and the radio frequency power amplifier 602 amplifies and outputs the radio frequency input signal.

Through the above radio frequency amplification apparatus provided in the embodiment of the present application, the voltage regulation apparatus has the capability of quickly adjusting the output voltage (at the nanosecond level) and ensuring the output current is continuous. Since the efficiency of the radio frequency power amplifier is lower when the output power is lower, the use of the voltage regulation apparatus can improve the efficiency of the radio frequency power amplifier at low output power, thereby enhancing the overall efficiency of the radio frequency power amplifier. In wireless communication devices, radio frequency power amplifiers account for a relatively high proportion of power consumption. Therefore, improving the efficiency of radio frequency power amplifiers can enhance the efficiency of wireless communication devices.

In addition, in communication base stations, the main function of the radio frequency power amplifier is to amplify and output RF signals. Applying the above-mentioned radio frequency amplification apparatus to wireless communication base stations can realize dynamic adjustment of the drain voltage of the radio frequency power amplifier, improve the efficiency of the radio frequency power amplifier, and thus achieve energy saving of the wireless communication device. In addition, the efficiency of the radio frequency power amplifier decreases significantly at low output power. By adjusting the drain voltage of the radio frequency power amplifier to match its output power, the efficiency of the radio frequency power amplifier in the full power range can be effectively improved.

Based on the same inventive concept, the embodiment of the present application also provides a voltage selection method, which can be applied to the above-mentioned voltage regulation apparatus.

Fig. 7 shows a flow chart of the voltage selection method provided by an embodiment of the present application. As shown in Fig. 7, the method mainly comprises the following steps.

Step 701: a voltage controller of a voltage regulation apparatus generates a voltage selection signal according to a received voltage regulation command, and sends the voltage selection signal to a multi-level power supply modulator of the voltage regulation apparatus.

For example, the voltage controller can input corresponding voltage selection signals to the switching transistor of each branch according to the target voltage signal indicated by the voltage regulation command and the magnitude of the input voltage of each branch of the multi-level power supply modulator. For details, please refer to the relevant descriptions above.

Step 702: the multi-level power supply modulator controls the conduction of a circuit from an input terminal of a target branch among multiple branches to a voltage output terminal according to the voltage selection signal.

Wherein the input voltage of the target branch matches the target voltage selected by the voltage selection signal,
Through the above method provided in the embodiment of the present application, the branch corresponding to the target voltage signal corresponding to the voltage regulation command can be selected to conduct, so as to output the corresponding target voltage.

In one implementation, in Step 702, the multi-level power supply modulator controls all switching transistors on the target branch to be turned on, controls the second type of switching transistor on the third branch to be turned on, and controls the second type of switching transistor on the fourth branch to be turned off, wherein the third branch is the branch among the multiple branches with the input voltage at the input terminal lower than the input voltage of the target branch, and the fourth branch is the branch among the multiple branches with the input voltage at the input terminal higher than the input voltage of the target branch.

For the specific logic control methods of the switching transistors on each branch, please refer to the relevant descriptions of the voltage regulation apparatus mentioned above, and they will not be repeated here.

The embodiments of the present application have been described above in conjunction with the accompanying drawings. However, the present application is not limited to the above-mentioned specific implementations. The above-mentioned specific implementations are merely illustrative and not restrictive. Under the inspiration of the present application, those skilled in the art can make many forms without departing from the purpose of the present application and the scope protected by the claims, all of which fall within the protection of the present application.

## Claims

1. A voltage regulation apparatus, comprising: a voltage controller and a multi-level power supply modulator, wherein the multi-level power supply modulator comprises multiple branches, an input voltage is input into an input terminal of any branch, and the other terminal thereof is connected to a voltage output terminal of the multi-level power supply modulator, each branch is provided with one or two switching transistors;
wherein the voltage controller is used for generating a voltage selection signal according to a received voltage regulation command, and sending the voltage selection signal to the multi-level power supply modulator;
wherein the multi-level power supply modulator is used for controlling, according to the voltage selection signal, the conduction of a circuit from an input terminal of a target branch among the multiple branches to the voltage output terminal.

2. The apparatus according to claim 1, wherein the switching transistor comprises:
a first type of switching transistor, wherein a first terminal of the first type of switching transistor is connected to the input terminal, and a second terminal thereof is connected to either the voltage output terminal or a second terminal of a second type of switching transistor, when the first type of switching transistor is turned off, the circuit in a first direction is conductive, and the circuit in a second direction is off, and when the first type of switching transistor is turned on, both the circuit in the first direction and the circuit in the second direction are conductive; wherein the first direction is the direction from the first terminal of the first type of switching transistor to the second terminal of the first type of switching transistor, and the second direction is the direction from the second terminal of the first type of switching transistor to the first terminal of the first type of switching transistor;
the second type of switching transistor, wherein a first terminal of the second type of switching transistor is connected to the voltage output terminal, and a second terminal of the second type of switching transistor is connected to either the input terminal or the second terminal of the first type of switching transistor, when the second type of switching transistor is turned off, the circuit in a third direction is conductive, and the circuit in a fourth direction is off, and when the second type of switching transistor is turned on, both the circuit in the third direction and the circuit in the fourth direction are conductive; wherein the third direction is the direction from the first terminal of the second type of switching transistor to the second terminal of the second type of switching transistor, and the fourth direction is the direction from the second terminal of the second type of switching transistor to the first terminal of the second type of switching transistor.

3. The apparatus according to claim 2, wherein among the multiple branches, a branch with the lowest input voltage at the input terminal is provided with one first switching transistor, and the first switching transistor is the first type of switching transistor; a branch with the highest input voltage at the input terminal is provided with a second switching transistor, and the second switching transistor is the second type of switching transistor.

4. The apparatus according to claim 3, wherein among the multiple branches, each branch with an input voltage between the lowest input voltage and the highest input voltage at the input terminal is provided with two switching transistors, one of which is the first type of switching transistor and the other is the second type of switching transistor.

5. The apparatus according to any one of claims 2 to 4, wherein the first type of switching transistor on a first branch and the second type of switching transistor on a second branch are complementary logic, wherein the first branch is any branch among the multiple branches except the branch with the highest input voltage at the input terminal, and the second branch is the branch among the multiple branches with the smallest difference between the input voltage thereof and the input voltage of the first branch, and the input voltage of the second branch is higher than the input voltage of the first branch.

6. The apparatus according to claim 5, wherein within a dead zone between the first type of switching transistor on the first branch and the second type of switching transistor on the second branch, the first type of switching transistor on the first branch is turned off before the second type of switching transistor on the second branch is turned on, or the first type of switching transistor on the first branch is turned on after the second type of switching transistor on the second branch is turned off.

7. The apparatus according to claim 5, wherein all the switching transistors on the target branch are turned on, the second type of switching transistor on a third branch is turned on, and the second type of switching transistor on a fourth branch is turned off, wherein the third branch is the branch among the multiple branches with the input voltage at the input terminal lower than the input voltage of the target branch, and the fourth branch is the branch among the multiple branches with the input voltage at the input terminal higher than the input voltage of the target branch.

8. The apparatus according to claim 5, wherein
the voltage controller is used for sending a first voltage selection signal to a control terminal of the second type of switching transistor on the second branch and a second voltage selection signal to a control terminal of the first type of switching transistor on the first branch when a target voltage signal selected by the voltage regulation command is equal to the input voltage of the first branch, and sending the second voltage selection signal to the control terminal of the second type of switching transistor on the second branch and the first voltage selection signal to the control terminal of the first type of switching transistor on the first branch when the target voltage signal is not equal to the input voltage of the first branch, wherein the first voltage selection signal is a signal that controls the first type of switching transistor or the second type of switching transistor to turn off, and the second voltage selection signal is a signal that controls the first type of switching transistor or the second type of switching transistor to turn on.

9. The apparatus according to claim 8, wherein the voltage controller comprises: n pairs of comparators and NOT gates, where n is the number of the first branches included in the multiple branches, and one pair of the comparator and NOT gate corresponds to one first branch; wherein, in any pair of the comparator and NOT gate,
the output terminal of the comparator is connected to the control terminal of the second type of switching transistor on the second branch, and the output terminal of the comparator is connected to the control terminal of the first type of switching transistor on the first branch through the NOT gate;
the target voltage signal and the input voltage of the first branch are input to the input terminal of the comparator, when the target voltage signal is equal to the input voltage of the first branch, the comparator outputs the first voltage selection signal, and when the target voltage signal is not equal to the input voltage of the first branch, the comparator outputs the second voltage selection signal.

10. A radio frequency amplification apparatus, comprising a radio frequency power amplifier and a voltage regulation apparatus according to any one of claims 1 to 9, wherein the power input terminal of the radio frequency power amplifier is connected to the voltage output terminal of the voltage regulation apparatus, and the radio frequency power amplifier is used to amplify and output the input RF signal under the action of the output voltage of the voltage regulation apparatus.

11. The apparatus according to claim 10, wherein there are multiple radio frequency power amplifiers, and the output terminal of the voltage regulation apparatus is connected to the power input terminal of each of the multiple radio frequency power amplifiers.

12. A voltage selection method, applied to a voltage regulation apparatus, the method comprising:
generating, by a voltage controller of the voltage regulation apparatus, a voltage selection signal according to a received voltage regulation command, and sending the voltage selection signal to a multi-level power supply modulator of the voltage regulation apparatus;
controlling, by the multi-level power supply modulator and according to the voltage selection signal, all switching transistors on a target branch to be turned on, controlling a second type of switching transistor on a third branch to be turned on, and controlling a second type of switching transistor on a fourth branch to be turned off, wherein the input voltage of the target branch matches the target voltage selected by the voltage selection signal, the third branch is a branch among multiple branches with an input voltage at an input terminal lower than an input voltage of the target branch, and the fourth branch is a branch among the multiple branches with an input voltage at an input terminal higher than the input voltage of the target branch.
